(19) Europäisches Patentamt
European Patent Office
Office européen des brevets

(11) **EP 3 800 479 B1**

(12) **EUROPÄISCHE PATENTSCHRIFT**

(45) Veröffentlichungstag und Bekanntmachung des Hinweises auf die Patenterteilung:
**22.03.2023 Patentblatt 2023/12**

(21) Anmeldenummer: **19201066.8**

(22) Anmeldetag: **02.10.2019**

(51) Internationale Patentklassifikation (IPC):
**G01R 33/36** *(2006.01)* **G01R 33/565** *(2006.01)*

(52) Gemeinsame Patentklassifikation (CPC):
**G01R 33/36;** G01R 33/3685; G01R 33/5659

(54) **MAGNETRESONANZTOMOGRAPH MIT EINER LEITUNG MIT SENSOR ZUM ERFASSEN LEITUNGSGEBUNDENER STÖRUNGEN**

MAGNETIC RESONANCE TOMOGRAPH WITH A LINE WITH SENSOR FOR DETECTING LINE INTERFERENCE

TOMOGRAPHE À RÉSONANCE MAGNÉTIQUE AVEC UN CONDUIT POURVU DE CAPTEUR PERMETTANT DE DÉTECTER DES PERTURBATIONS DE CONDUCTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.04.2021 Patentblatt 2021/14**

(73) Patentinhaber: **Siemens Healthcare GmbH 91052 Erlangen (DE)**

(72) Erfinder:
• **Biber, Stephan**
**91056 Erlangen (DE)**
• **Vester, Markus**
**90471 Nürnberg (DE)**

(56) Entgegenhaltungen:
**EP-A1- 3 467 531 EP-A1- 3 667 348**
**JP-A- H04 109 933 US-A1- 2004 164 739**
**US-A1- 2017 108 569 US-A1- 2018 292 480**
**US-A1- 2019 025 389**

• **S.B. BULUMULLA ET AL: "Inductively coupled wireless RF coil arrays", MAGNETIC RESONANCE IMAGING, Bd. 33, Nr. 3, 1. April 2015 (2015-04-01), Seiten 351-357, XP055676372, TARRYTOWN, NY, US ISSN: 0730-725X, DOI: 10.1016/j.mri.2014.12.004**

**Beschreibung**

Die Erfindung betrifft einen Magnetresonanztomographen mit einer Leitung für eine elektrische Verbindung in einem Magnetresonanztomographen mit einem Anschluss an den Magnetresonanztomographen. Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Magnetresonanztomographen erfordern in zweierlei Hinsicht eine Hochfrequenzabschirmung. Zum einen werden zur Anregung der Kernspins Hochfrequenzimpulse mit Leistungen im Kilowattbereich erzeugt, die nur teilweise im Patienten absorbiert werden. Radiowellen, die die Patientendurchführung verlassen, werden in den Raum abgestrahlt und müssen daher zur Einhaltung von Emissionsgrenzwerten abgeschirmt werden.

Umgekehrt sind die für die Bildgebung zu empfangenden Magnetresonanzsignale extrem schwach. Um hier ein ausreichendes Signal-zu-Rausch-Verhältnis (SNR) zu erreichen, ist eine Abschirmung externer Störsignal erforderlich.

Deshalb werden im Stand der Technik um einen Magnetresonanztomographen aufwändige Schirmkabinen installiert, um sowohl Emissionen als auch Immissionen zu reduzieren.

Aus dem Dokument US 2004/164739 A1 ist ein System zum Erfassen von transienten Störungen bekannt. Das System weist ein Bildgebungssystem mit einer magnetischen Feldspule und einem Bilderfassungstunnel auf. Das Bildgebungssystem erzeugt ein Bilderfassungssignal in einem Kabel, wobei das Bilderfassungssignal durch ein Störsignal gestört werden kann. Ein Störerfassungssensor ist außerhalb des Bilderfassungstunnels nahe bei dem Signalkabel angeordnet. Dieser Störerfassungssensor erfasst das Störereignis von dem Signalkabel und erzeugt ein Störsignal daraus.

Das Dokument US 2019/025389 A1 beschreibt ein niedrig-Feld Magnetresonanzsystem, das eine Antenne umfassen kann, die kapazitiv an eine der Stromzuführungsleitungen des Systems gekoppelt ist und Messignale, die von der Antenne erfasst werden, zur Störunterdrückung in einem Hochfrequenzsignal der primären Hochfrequenzempfangsantenne nutzt. Eine derartige Antenne kann eine dünne Metallfolie aufweisen, die um die Stromzuführungsleitung gewickelt ist und/oder einen oder mehrere Kapazitäten, die an die Stromzuführungsleitung gekoppelt sind.

Aus dem Dokument von S.B. Bulumulla ET AL: "Inductively coupled wireless RF coil arrays", MAGNETIC RESONANCE IMAGING, Bd. 33, Nr. 3, 1. April 2015 (2015-04-01), Seiten 351-357, XP055676372, TARRYTOWN, NY, US ISSN: 0730-725X, DOI: 10.1016/j.mri. ist eine induktiv gekoppelte, mehrkanalige Antennenmatrix bekannt. Diese ist induktiv bzw. "drahtlos" an sekundäre Erfassungsspulen gekoppelt, deren Ausgangssignal über Vorverstärker an einen Magnetresonanz-Systemschrank übertragen werden.

Aus der nicht vorveröffentlichten Patentanmeldung EP 3 667 348 A1 ist ein Magnetresonanztomograph sowie ein Verfahren zum Betrieb des Magnetresonanztomographen bekannt. Der Magnetresonanztomograph weist einen Sender zum Erzeugen von Anregungspulsen mit einer Wellenlänge Lambda, eine Antenne zum Aussenden der Anregungspulse, eine Speiseleitung und einen Spannungssensor auf. Der Spannungssensor ist an der Speiseleitung in einem effektiven Abstand, der einem Vielfachen der halben Wellenlänge Lambda entspricht, von einem Speisepunkt an der Antenne angeordnet.

Es könnte daher eine Aufgabe der Erfindung sein, den Aufwand für eine Abschirmung zu reduzieren.

Die Aufgabe wird durch einen erfindungsgemäßen Magnetresonanztomographen nach Anspruch 1 gelöst.

Der erfindungsgemäße Magnetresonanztomograph weist eine Leitung für eine elektrische Verbindung mit dem Magnetresonanztomographen auf. Die Leitung weist elektrische Leiter auf, die einen elektrischen Strom führen können. Durch die elektrische Leitfähigkeit wirken die Leiter auch als Antennen für elektromagnetische Wellen und können deshalb elektrische Störungen kapazitiv oder durch Induktion aufnehmen bzw. aussenden und auch entlang ihrer Erstreckung weiterleiten, beispielsweise in einen abgeschirmten Bereich. Die erfindungsgemäße Leitung weist einen Anschluss, beispielsweise eine feste elektrische Verbindung oder elektrische Steckverbindung zu dem Magnetresonanztomographen auf.

Die Leitung weist einen elektrischen Störleiter auf. Darunter ist ein Leiter zu verstehen, der durch seine Anordnung oder Verschaltung in der Lage ist, ein Störsignal zu übertragen. Als Störsignal im Sinne dieser Erfindung wird dabei jedes Signal betrachtet, dass nicht zur Bilderfassung beiträgt und die Qualität der bereitgestellten Bilder beeinträchtigen kann. Es kann sich dabei also auch um Signale handeln, die zwar zur Bilderfassung notwendig sind, aber nicht unmittelbar Bildinformation tragen. Beispiele sind Störungen auf Stromversorgungsleitungen, Steuerleitungen, Kommunikationsleitungen, wie zum Beispiel die Verständigungseinrichtungen mit dem Patienten, oder eine Beleuchtung im Patiententunnel. Aber auch unmittelbar für die Bilderzeugung relevante Leitungen wie Gradientenspulenanschlussleitungen, Shim-Stromleitungen, und deren Signale können bei der Bilderfassung zu Artefakten führen und werden in diesem Sinne als Störleiter betrachtet.

Der elektrische Störleiter kann dabei auch ein Leiter der Leitung sein, der eigentlich dafür vorgesehen ist, die Signalleitungen der Leitung vor Störsignalen zu schützen. Beispielsweise kann ein Außenleiter einer Koaxialleitung auch selbst Störsignale als Leiter in einen geschirmten Raum eintragen. Auch können mehrere Leiter bzw. Adern einer Leitung Störleiter sein.

Das Merkmal, dass der Störleiter ausgelegt ist, ein elektromagnetisches Störsignal aus der Umgebung aufzunehmen und/oder in diese abzustrahlen gibt dabei lediglich an, dass diese durch die elektrischen Eigenschaften und die Anordnung des Störleiters möglich ist und dieser dadurch eine potentielle Quelle für einen Störeintrag darstellt. Es soll jedoch in keiner Weise im Sinne des Patentanspruchs erforderlich sein, dass der Störleiter mit einem zusätzlichen Störsignal beaufschlagt ist bzw. wird.

Die erfindungsgemäße Leitung weist weiterhin einen Sensor auf, der in elektrischer und/oder magnetischer Kopplung mit der Störleitung ist. Unterschiedliche denkbare Ausführungsformen der Kopplung sind im Einzelnen in den Unteransprüchen angegeben.

Der Sensor ist über eine Signalverbindung mit dem Magnetresonanztomographen verbindbar, über die das aufgenommene Störsignal von dem Störleiter an eine Steuerung des Magnetresonanztomographen weitergeleitet werden kann. Dies ermöglicht der Steuerung, das so bekannte Störsignal in den Magnetresonanzsignalen zu erkennen und zu unterdrücken.

Der Sensor weist einen Richtkoppler auf. Als Richtkoppler ist hierbei jede Kopplungseinrichtung zu verstehen, die als Koppelement ein Signal liefert, das abhängig von der Ausbreitungsrichtung eines Störsignals auf dem Störleiter ist. Ein Richtkoppler lässt sich beispielsweise durch Streifenleitungen parallel zum Störleiter oder Transformatoren realisieren.

Auf vorteilhafte Weise ermöglicht der erfindungsgemäße Magnetresonanztomograph mit einem Sensor, Störsignale auf Leitungen möglichst an der Quelle bzw. an einem Ort zu erkennen und/oder zu erfassen, wo sie von den Nutzsignalen gut getrennt vorliegen, sodass sie anschließend in der Bilderfassung effektiv unterdrückt werden können.

Ein Richtkoppler kann unterscheiden, ob ein Signal von einer Lokalspule kommt oder sich in Richtung zu der Lokalspule bewegt. Während Störungen bei der Bilderfassung problematisch sind, die in Richtung der Lokalspule laufen, führen parasitäre Magnetresonanzsignale erst zu Artefakten, wenn diese irrtümlich für Störsignale gehalten werden und versucht wird, diese zu kompensieren. Ein Richtkoppler erlaubt es dabei auf Vorteilhafte Weise, beide Signale zu trennen und lediglich die Störsignale zu unterdrücken.

Weitere vorteilhafte Ausführungsformen sind in den Unteransprüchen angegeben.

In einer möglichen Ausführungsform des erfindungsgemäßen Magnetresonanztomographen ist der Sensor auf einer Larmorfrequenz des Magnetresonanztomographen resonant. Als Larmorfrequenz wird dabei die Magnetresonanzfrequenz der zu erfassenden Kernspins im statischen magnetischen Feld B0 des Magnetresonanztomographen bezeichnet. Die Resonanz kann beispielsweise bei einer induktiven Ankopplung mittels Spule durch eine mit der Spule verbundenen Kapazität erreicht werden.

Zur Bildgebung werden bei einem Magnetresonanztomographen Magnetresonanzsignale von Kernspins erfasst, die die Larmorfrequenz aufweisen. Die Bilderfassung ist daher besonders sensibel für Störungen mit dieser Frequenz. Durch einen auf dieser Frequenz resonanten Sensor können wiederum die besonders relevanten Störsignale mit höherer Amplitude und somit besser erfasst werden.

In einer denkbaren Ausführungsform des erfindungsgemäßen Magnetresonanztomographen weist der Sensor einen Schutz gegen einen Anregungspuls des Magnetresonanztomographen auf. Der Anregungspuls für die Kernspins mit Leistungen bis zu Kilowatt auf der Larmorfrequenz kann insbesondere bei einem auf dieser Frequenz resonanten Sensor zur Beschädigung von Eingangselementen führen. Der Sensor kann deshalb beispielsweise passive Dioden zum Kurzschluss der auftretenden Spannungen oberhalb der Sperrspannung aufweisen. Auch aktive Schaltungen, die den Sensor gesteuert von der Steuerung verstimmen, sind möglich.

Auf vorteilhafte Weise verhindern die Schutzelemente eine Beschädigung des Sensors durch den Magnetresonanztomographen.

In einer möglichen Ausführungsform des erfindungsgemäßen Magnetresonanztomographen ist der Sensor benachbart zu einem Patiententunnel angeordnet. Der Patiententunnel gibt hierbei den Ort an, an dem Magnetresonanzsignale zur Bilderfassung empfangen werden und der deshalb besonders sensitiv für Störungen ist. Als benachbart wird dabei ein Abstand angesehen, der kleiner als 50%, 20% oder 10% der Länge der Leitung oder einer Vakuumwellenlänge einer Radiowelle bei der Larmorfrequenz des Magnetresonanztomographen ist.

Die Anordnung des Sensors an der Leitung in der Nähe bzw. benachbart zu dem Patiententunnel stellt auf vorteilhafte Weise sicher, dass möglichst wenige Störungen zwischen Sensor und Patiententunnel eingestrahlt, aber nicht durch den Sensor erfasst werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:

Fig. 1     eine schematische Darstellung eines erfindungsgemäßen Magnetresonanztomographen;

Fig. 2     eine schematische Darstellung einer nicht-erfindungsgemässen Leitung eines Magnetresonanztomographen mit einem Sensor;

Fig. 3     eine schematische Darstellung einer nichterfindungsgemässenLeitung eines Magnetresonanztomographen mit einem Sensor;

Fig. 4     eine schematische Darstellung einer nicht-erfindungsgemässen Leitung eines Magnetresonanztomographen mit einem Sensor;

Fig. 5     eine schematische Darstellung einer Ausführungsform einer Leitung des erfindungsgemäßen Magnetresonanztomographen mit einem Sensor;

Fig. 6     eine schematische Darstellung eines nichterfindungsgemässen Sensors eines Magnetresonanztomographen;

Fig. 7     eine schematische Darstellung eines nichterfindungsgemässen Sensors eines Magnetresonanztomographen.

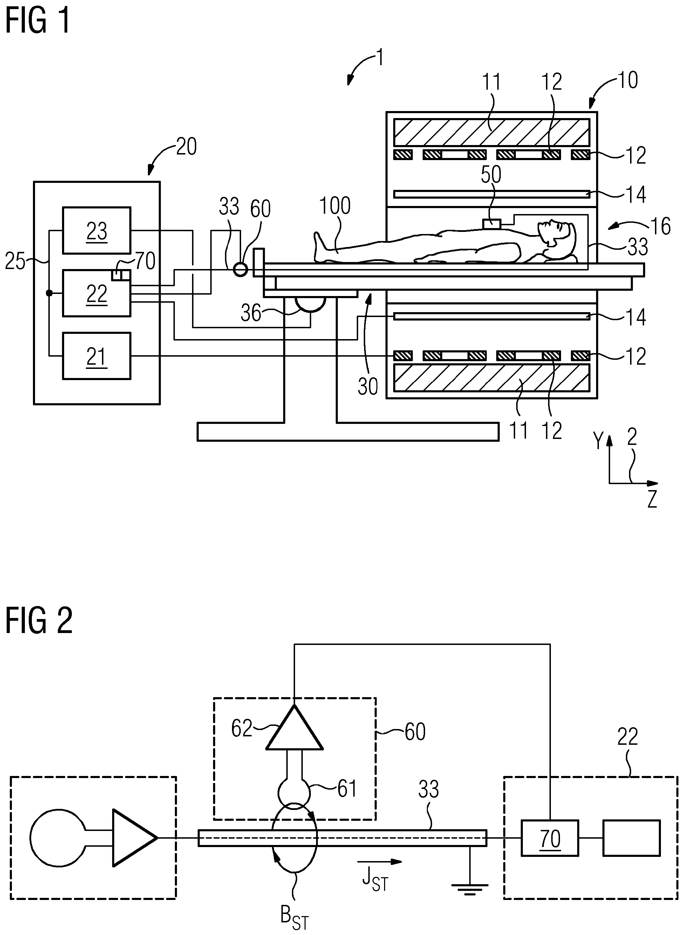

Fig. 1 zeigt eine schematische Darstellung einer Ausführungsform eines erfindungsgemäßen Magnetresonanztomographen 1 mit einer 33 mit Sensor 60.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist eine Lokalspule 50 angeordnet, die über eine Leitung 33 mit der Hochfrequenzeinheit 22 und deren Empfänger 70 verbunden ist. Denkbar ist es aber auch, dass die Körperspule 14 Magnetresonanzsignale empfängt und an den Empfänger 70 weiterleitet.

Der Patiententunnel hat vorzugsweise einen Radius R für den gilt:

$$R < (Lambda_L * 1,841) / (2 * Pi)$$

Lambda$_L$ gibt dabei die Wellenlänge einer Radiowelle in Luft bei der Larmorfrequenz des Magnetresonanztomographen 1 an. Ist der Radius R kleiner als der rechte Term, so breitet sich die Radiowelle in dem Patiententunnel 16 exponentiell gedämpft aus und das Störsignal ist in der Mitte im Untersuchungsbereich FoV stark gedämpft. Lambda$_L$ wird auch als Grenzwellenlänge eines Rundhohlleiters bezeichnet, die dazugehörige Frequenz als Grenzfrequenz.

Der exponentiellen Dämpfung unterliegen jedoch nicht elektromagnetische Signale, die durch einen elektrischen Leiter wie die Leitung 33 in den Patiententunnel 16 eingetragen werden, denn die Leitung 33 wirkt zusammen mit einer leitenden Wandung des Patiententunnels wie ein Koaxialleiter. Die Störung kann durch Induktion oder kapazitiv außerhalb des Patiententunnels 16 beispielsweise auf eine Abschirmung der Leitung 33 eingetragen werden. Die Leitung 33 wirkt dann als Störleiter im Sinne der Erfindung.

Die Lokalspule 50 empfängt folglich ein Gemisch aus Resonanzmagnetsignal und Störsignalen, die unter anderem über Störleiter in den Patiententunnel 16 eingetragen werden. Mittels aktiver Störunterdrückung, bei der das Störsignal skaliert und mit umgekehrtem Vorzeichen zu dem Signal der Lokalspule 50 von dem Empfänger 70 addiert wird, kann das Störsignal in dem Empfangssignal der Lokalspule reduziert oder im Idealfall ganz unterdrückt werden. Dazu muss jedoch das Störsignal selbst möglichst genau bekannt sein. Dann ist es beispielsweise durch Autokorrelation möglich, den Anteil des Störsignals in dem Empfangssignal der Lokalspule 50 zu bestimmen und durch geeignete Wahl von Phasenverschiebung und Verstärkung bzw. Abschwächung diesen wesentlich zu verringern oder ganz zu eliminieren.

Gemäß der Erfindung ist deshalb ein Sensor 60 an der Störleitung vorgesehen, um das von der Störleitung eingefangene und in den Patiententunnel 16 eingetragene Störsignal möglichst unverfälscht zu erfassen. Unterschiedliche Ausführungsformen des Sensors sind nachfolgend dargestellt.

In Fig. 2 ist ein nicht-erfindungsgemässes Beispiel einer Leitung 33 zwischen Lokalspule 50 und Empfänger 70 als Störleiter dargestellt. Auf dem Außenleiter der Koaxialleitung fließt ein durch ein elektromagnetisches Störfeld induzierter Wechselstrom $I_{ST}$. Quelle können Geräte in anderen Räumen oder Gebäuden sein. Der Wechselstrom $I_{ST}$ wiederum erzeugt ein magnetisches Wechselfeld $B_{ST}$, das die Signalleitung 33 bzw. den Störleiter umgibt. Der Sensor 60 nutzt dieses, indem eine Spule bzw. Induktionsschleife 61 an das magnetische Störfeld $B_{ST}$ ankoppelt. Idealerweise ist die Induktionsschleife 61 so relativ zu dem Störleiter ausgerichtet, dass ein Normalenvektor einer von der Induktionsschleife 61 umschlossenen Fläche tangential an die kreisförmig um die Signalleitung verlaufenden magnetischen Feldlinien des Magnetfeldes $B_{ST}$ orientiert ist. Auf diese Weise ist die in die Induktionsschleife 61 induzierte Spannung maximal und der Sensor 60 liefert ein möglichst großes und störungsarmes Störsignal. Vorzugsweise weist der Sensor 60 weiterhin einen rauscharmen Vorverstärker 62 (LNA) auf, der das induzierte Signal verstärkt, bevor es über eine Sensorleitung 63 an den Empfänger 70 weitergeleitet wird. Dabei kann die Induktionsschleife 61 auch mehrere Windungen aufweisen, um die induzierte Spannung zu erhöhen. Die Induktionsschleife 61 ist dabei galvanisch von dem Störleiter getrennt.

Grundsätzlich sind anstelle der Spule bzw. Induktionsschleife auch andere Sensoren 60 denkbar, die ein hochfrequentes magnetisches Wechselfeld in Amplitude und/oder Phase erfassen können, wie beispielsweise Hall-Detektoren oder Josephson-Kontakte bzw. SQID (superconducting quantum interference device).

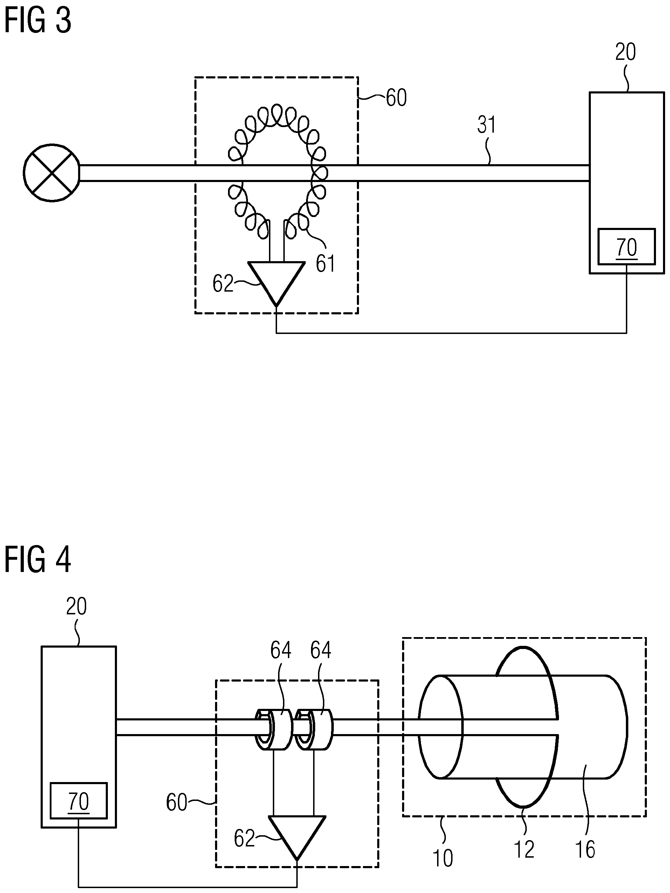

Fig. 3 zeigt ein nicht-erfindungsgemässes Beispiel des Sensors 60. Beispielhaft ist der Sensor 60 hier an einer Leitung 31 zur Energieversorgung einer Beleuchtung, beispielsweise für den Patiententunnel 16, angeordnet.

Der Sensor 60 weist hier eine Induktionsschleife 61 auf, deren Windungen um einen Körper gewickelt sind, der die Leitung 33 bzw. den Störleiter außenumfänglich umschließt. Denkbar ist auch, dass der Körper selbst virtuell ist, d.h. die Wicklung freitragend ohne Wickelkörper in dieser Form angeordnet ist. Vorzugsweise hat der Körper dabei die Form eines Toroid bzw. Zylinderrings, es ist aber auch denkbar, dass anstelle des Rings beispielsweise eine Ellipse, ein Ovoid oder auch ein Polygon den Störleiter umschließt. Ebenfalls ist es denkbar, dass der Querschnitt des Köpers und damit die Form einer einzelnen Windung der Induktionsschleife 61 nicht nur die Kreisform, sondern beispielsweise ebenfalls Ellipse, Polygon oder auch Mischformen wie D-förmig. Mit anderen Worten, die einzelnen Windungen erstrecken sich um den Körper und sind wiederum entlang des Umfangs um den Störleiter aneinandergereiht, sodass zwei Anschlüsse der Induktionsschleife 61, wie dargestellt nebeneinander zu liegen kommen, sodass diese mit geringem Abstand und kleiner umschlossener Fläche zurück zu dem rauscharmen Vorverstärker 62 geführt werden können.

Eine derart geformte Induktionsschleife 61 weist durch die Erstreckung entlang der Feldlinien mit einer maximalen von den Feldlinien $B_{ST}$ durchstoßenen umschlossenen Fläche eine maximale induzierte Spannung auf. Gleichzeitig ist der Sensor einfach aufzuschieben und ist unempfindlich gegen Positionsänderungen und externe, d.h. nicht auf dem Störleiter geführte Störsignale.

Fig. 4 zeigt eine weitere nicht-erfindungsgemässe Variante der Leitung 33. Hierbei wird beispielhaft als Störleitung eine Gradientenanschlussleitung angenommen, die die Steuerung 20 mit den Gradientenspulen 12 verbindet.

Hier erfolgt die Aufnahme des Störsignals nicht durch Induktion, sondern kapazitiv über die elektrische Feldkomponente des Störsignals. Der Sensor 60 kann einen, oder wie hier dargestellt, zwei kapazitive Koppelelemente 64 aufweisen. Diese sind in unmittelbarer Nähe, vorzugsweise außen an einem Isolator des Störleiters angeordnet und von diesem galvanisch getrennt. In diesen wird durch die elektrische Feldkomponente einer sich entlang des Störleiters ausbreitenden Hochfrequenzstörung eine Spannungsdifferenz verursacht, die von dem rauscharmen Vorverstärker 62 verstärkt und wiederum dem Empfänger 70 zugeführt wird. Denkbar ist es auch, dass lediglich ein kapazitives Koppelelement 64 vorgesehen ist und das Bezugspotential eine Signalmasse ist.

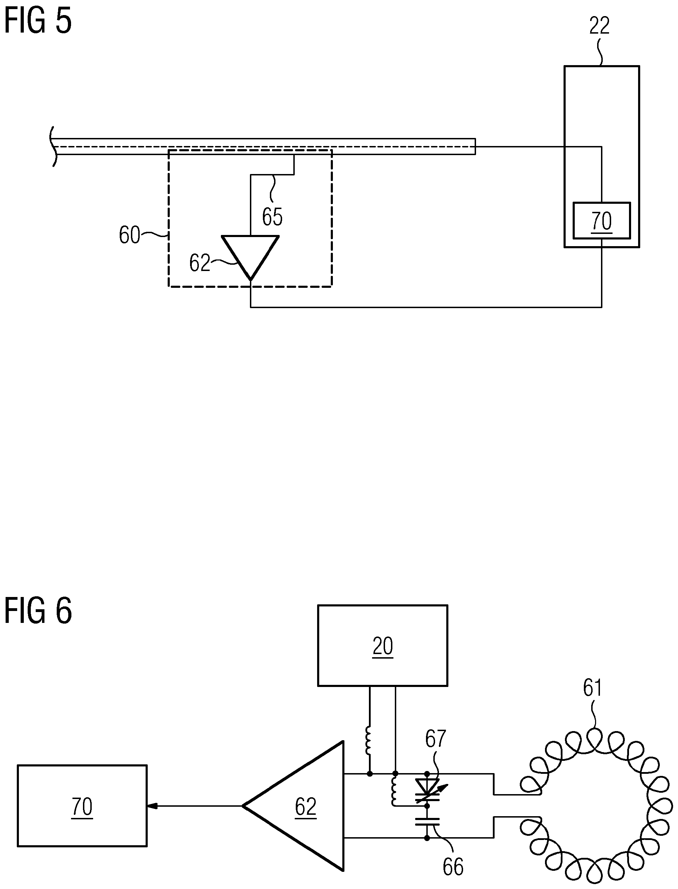

Die in Fig. 5 dargestellt Variante des Sensors des erfindungsgemäßen Magnetresonanztomographen 1 weist der Sensor einen Richtkoppler auf. Als Richtkoppler wird in diesem Zusammenhang jede Form eines Signalaufnehmers von dem Störleiter angesehen, der ein Signal liefert, das abhängig von einer Ausbreitungsrichtung des Störsignals auf dem Störleiter ist. Dies kann ein klassischer Richtkoppler sein, denkbar sind aber auch Kombinationen aus mehreren induktiven oder kapazitiven Koppelelementen, die ein richtungsabhängiges Signal liefern.

Der Richtkoppler ermöglicht, zwischen Signalen zu unterscheiden, deren Ausbreitungsrichtung von der Lokalspule 50 weg gerichtet und and solchen, die in die Lokalspule eingetragen werden. So kann auf vorteilhafte Weise ein parasitäres Magnetresonanzsignal auf einem Außenleiter des Koaxialkabels von einem eingetragenen Störsignal unterschieden werden, sodass nicht das Magnetresonanzsignal fehlerhaft als Störsignal identifiziert wird und dadurch Artefakte durch die Störunterdrückung bei der Bildauswertung verursacht werden.

In der Ausführungsform der Fig. 6 weist der erfindungsgemäße Sensor 60 ein Resonanzelement 66 auf, um den Sensor 60 für eine vorbestimmte Frequenz, vorzugsweise für die Larmorfrequenz des Magnetresonanztomographen 1, besonders sensitiv zu machen. Da die Bilderfassung durch Magnetresonanzsignale von Kernspins erfolgt, deren Frequenz bei dem statischen Magnetfeld B0 der Larmorfrequenz der Spins in diesem Magnetfeld entspricht, reagiert diese insbesondere empfindlich auf Störungen in diesem Frequenzbereich. Eine bessere Störunterdrückung ist hier also besonders effektiv und kann durch höhere Ausgangssignale des Sensors 60 in diesem Frequenzbereich erzielt werden. Dies lässt sich beispielsweise durch eine Resonanz des Sensors mit einem Amplitudenmaximum auf der Larmorfrequenz erreichen. Für die in Fig. 6 beispielhaft dargestellte (nicht-erfindungsgemässe) Toroidspule ist dies durch eine Kapazität als Resonanzelement 66 in einem Parallelschwingkreis möglich.

Durch einen großen Dynamikumfang zwischen Störsignal und Magnetresonanzsignal auf der einen Seite und dem Hochfrequenz-puls zur Anregung der Kernspins auf der anderen Seite ist es insbesondere bei einem resonanten Sensor möglich, dass beispielsweise durch hohe Eingangsamplituden während des Anregungspulses der Sensor, insbesondere der rauscharme Verstärker 62 beschädigt wird. Als Schutz kann deshalb ein aktives Schutzelement 67 vorgesehen sein, hier in Form einer Pin-Diode, das gesteuert von der Steuerung 20 das Eingangssignal des rauscharmen Verstärkers 62 reduziert. Dies kann wie in Fig. 6 dargestellt dadurch erreicht werden, dass die PIN-Diode als variable Kapazität den Resonanzkreis aus Induktionsschleife 61 und dem Resonanzelement 66 verstimmt. Denkbar wären es aber auch beispielsweise, dass die PIN-Diode als Schalter betrieben wird, der den Resonanzkreis kurzschließt oder durch zugeschaltete Kapazitäten oder Induktivitäten verstimmt. Dazu können auch andere mechanische oder elektronische Schalter Verwendung finden.

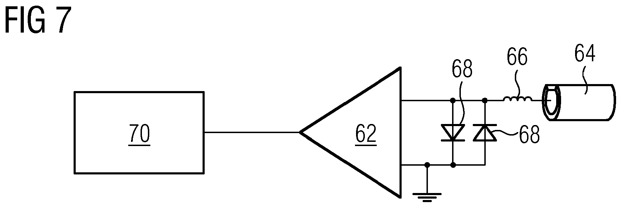

Fig. 7 zeigt ein Beispiel des nicht-erfindungsgemässen Sensors 60 mit einem kapazitiven Koppelement 64, das durch eine Induktivität als Resonanzelement 66 auf die Larmorfrequenz gestimmt wird. In dieser Figur ist auch ein beispielhaftes passives Schutzelement 68 verwirklicht, das aus zwei antiparallelen Dioden besteht, die jedes Signal größer der Schwellspannung kurzschließen und so begrenzen.

Denkbar sind auch andere Kombinationen von induktivem Aufnehmer bzw. Induktionsschleite 61 oder kapazitivem Koppelement 64 jeweils mit aktiven Schutzelementen 67 und/oder passiven Schutzelementen 68.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Magnetresonanztomograph mit einer Leitung (33) für eine elektrische Verbindung in einem Magnetresonanztomographen (1) mit einem Anschluss an den Magnetresonanztomographen (1), wobei die Leitung (33) einen elektrischen Störleiter aufweist, der ausgelegt ist, ein elektromagnetisches Störsignal aus der Umgebung aufzunehmen und/oder in diese abzustrahlen, wobei die Leitung (33) einen Sensor (60) aufweist, der in elektrischer und/oder magnetischer Kopplung mit der Störleitung steht, wobei die Leitung (33) eine Signalverbindung aufweist, die ausgelegt ist, das von dem Sensor aufgenommene Störsignal an dem Anschluss dem Magnetresonanztomographen (1) zur Verarbeitung bereitzustellen, wobei der Sensor über die Signalverbindung mit dem Magnetresonanztomographen verbindbar ist, über die das aufgenommene Störsignal von dem Störleiter an eine Steuerung des Magnetresonanztomographen weitergeleitet werden kann, **dadurch gekennzeichnet, dass**

   der Sensor (60) einen Richtkoppler (65) aufweist,
   wobei der Magnetresonanztomograph (1) eine Steuerung (23) aufweist, die ausgelegt ist, aus empfangenen Magnetresonanzsignalen in Abhängigkeit von den aufgenommenen Störsignalen des Sensors (60) eine Magnetresonanzabbildung zu erzeugen.

**2.** Magnetresonanztomograph nach einem der vorhergehenden Ansprüche, wobei der Sensor (60) einen Schutz gegen einen Anregungspuls des Magnetresonanztomographen (1) aufweist.

**3.** Magnetresonanztomograph nach Anspruch 1, wobei der Sensor (60) benachbart zu einem Patiententunnel (16) angeordnet ist.

**4.** Magnetresonanztomograph nach Anspruch 3, wobei der Sensor (60) auf einer Larmorfrequenz des Magnetresonanztomographen (1) resonant ist.

## Claims

**1.** Magnetic resonance tomography apparatus with a line (33) for an electrical connection in a magnetic resonance tomography apparatus (1) with a connector to the magnetic resonance tomography apparatus (1), wherein the line (33) comprises an electrical interference conductor, which is configured to pick up an electromagnetic interference signal from the environment and/or irradiate said signal into the environment, wherein the line (33) comprises a sensor (60), which is electrically and/or magnetically coupled to the interference line, wherein the line (33) comprises a signal connection, which is configured to provide the interference signal picked up by the sensor at the connector to the magnetic resonance tomography apparatus (1) for processing, wherein the sensor can be connected to the magnetic resonance tomography apparatus via a signal connection via which the interference signal picked up by the interference conductor can be relayed to a control system of the magnetic resonance tomography apparatus,
**characterised in that**
the sensor (60) comprises a directional coupler (65), wherein the magnetic resonance tomography apparatus (1) comprises a control system (23), which is configured to generate magnetic resonance imaging from received magnetic resonance signals in dependence on the interference signals picked up by the sensor (60).

**2.** Magnetic resonance tomography apparatus according to one of the preceding claims, wherein the sensor (60) is protected against an excitation pulse of the magnetic resonance tomography apparatus (1).

**3.** Magnetic resonance tomography apparatus according to claim 1, wherein the sensor (60) is arranged adjacent to a patient tunnel (16).

**4.** Magnetic resonance tomography apparatus according to claim 3, wherein the sensor (60) resonates at a Larmor frequency of the magnetic resonance tomography apparatus (1).

## Revendications

**1.** Tomodensitomètre à résonance magnétique comprenant une ligne (33) de liaison électrique dans un tomodensitomètre (1) à résonance magnétique ayant une borne sur le tomodensitomètre (1) à résonance magnétique, dans lequel la ligne (33) a un conducteur électrique parasite, qui est conçu pour recevoir un signal électromagnétique parasite de l'atmosphère ambiante et/ou le rayonner dans celle-ci, dans lequel la ligne (33) a un capteur (60), qui est un couplage électrique et/ou magnétique avec la ligne parasite, dans lequel la ligne (33) a une liaison de signal, qui est conçue pour mettre à disposition, pour le traitement à la borne du tomodensitomètre (1) à résonance magnétique, le signal parasite reçu par le capteur, dans lequel le capteur peut être relié au tomodensitomètre à résonance magnétique par la liaison de signal, par laquelle le signal parasite reçu peut être acheminé du conducteur parasite à une commande du tomodensitomètre à résonance magnétique,
**caractérisé en ce que**
le capteur (60) a un coupleur (65) directionnel, dans lequel le tomodensitomètre (1) à résonance magnétique a une commande (23), qui est conçue pour produire, à partir de signaux de résonnance magnétique reçus, une représentation de résonance magnétique en fonction des signaux parasites reçus du capteur (60).

**2.** Tomodensitomètre à résonance magnétique suivant l'une des revendications précédentes, dans lequel le capteur (60) a une protection vis-à-vis d'une impulsion d'excitation du tomodensitomètre (1) à résonance magnétique.

**3.** Tomodensitomètre à résonance magnétique suivant la revendication 1, dans lequel le capteur (60) est monté au voisinage d'un tunnel (16) pour un patient.

**4.** Tomodensitomètre à résonance magnétique suivant la revendication 3, dans lequel le capteur (60) est résonant sur une fréquence de Larmor du tomodensitomètre (1) à résonance magnétique.

# FIG 1

# FIG 2

FIG 3

20

60

31

70

61

62

FIG 4

20

64    64

60

62

70

10    12    16

# FIG 5

# FIG 6

FIG 7

**IN DER BESCHREIBUNG AUFGEFÜHRTE DOKUMENTE**

**In der Beschreibung aufgeführte Patentdokumente**

- US 2004164739 A1
- US 2019025389 A1

- EP 3667348 A1

**In der Beschreibung aufgeführte Nicht-Patentliteratur**

- **S.B. BULUMULLA et al.** nductively coupled wireless RF coil arrays. *MAGNETIC RESONANCE IMAGING,* 01. April 2015, vol. 33 (3), ISSN 0730-725X, 351-357